(19) Europäisches Patentamt / European Patent Office / Office européen des brevets

(11) EP 3 295 495 B1

(12) # EUROPEAN PATENT SPECIFICATION

(45) Date of publication and mention of the grant of the patent:
**26.08.2020 Bulletin 2020/35**

(21) Application number: **16723482.2**

(22) Date of filing: **13.05.2016**

(51) Int Cl.:
***H01L 51/54** (2006.01)* ***C09K 11/06** (2006.01)*

(86) International application number:
**PCT/GB2016/051388**

(87) International publication number:
**WO 2016/185183 (24.11.2016 Gazette 2016/47)**

(54) **LIGHT-EMITTING COMPOUND**
LICHTEMITTIERENDE VERBINDUNG
COMPOSÉ D'ÉMISSION DE LUMIÈRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.05.2015 GB 201508441**

(43) Date of publication of application:
**21.03.2018 Bulletin 2018/12**

(73) Proprietors:
- **Cambridge Display Technology Limited**
  **Cardinal Way**
  **Godmanchester**
  **Cambridgeshire PE29 2XG (GB)**
- **Sumitomo Chemical Co., Ltd.**
  **Tokyo 104-8260 (JP)**

(72) Inventors:
- **TARRAN, William**
  **Godmanchester**
  **Cambridgeshire PE29 2XG (GB)**
- **KAMTEKAR, Kiran**
  **Godmanchester**
  **Cambridgeshire PE29 2XG (GB)**

(74) Representative: **Gilani, Anwar et al**
**Venner Shipley LLP**
**Byron House**
**Cambridge Business Park**
**Cowley Road**
**Cambridge CB4 0WZ (GB)**

(56) References cited:
**JP-A- 2012 222 268**
**US-A1- 2012 248 969**
**US-A1- 2014 151 659**
**US-A1- 2014 374 727**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### Field of the Invention

The present invention relates to light-emitting compounds, in particular phosphorescent light-emitting compounds; compositions, solutions and light-emitting devices comprising said light-emitting compounds; and methods of making said light-emitting devices.

### Background of the Invention

Electronic devices containing active organic materials are attracting increasing attention for use in devices such as organic light emitting diodes (OLEDs), organic photoresponsive devices (in particular organic photovoltaic devices and organic photosensors), organic transistors and memory array devices. Devices containing active organic materials offer benefits such as low weight, low power consumption and flexibility. Moreover, use of soluble organic materials allows use of solution processing in device manufacture, for example inkjet printing or spin-coating.

An OLED may comprise a substrate carrying an anode, a cathode and one or more organic light-emitting layers between the anode and cathode.

Holes are injected into the device through the anode and electrons are injected through the cathode during operation of the device. Holes in the highest occupied molecular orbital (HOMO) and electrons in the lowest unoccupied molecular orbital (LUMO) of a light-emitting material combine to form an exciton that releases its energy as light.

Suitable light-emitting materials include small molecule, polymeric and dendrimeric materials. Suitable light-emitting polymers include poly(arylene vinylenes) such as poly(p-phenylene vinylenes) and polyarylenes such as polyfluorenes.

A light emitting layer may comprise a semiconducting host material and a light-emitting dopant wherein energy is transferred from the host material to the light-emitting dopant. For example, J. Appl. Phys. 65, 3610, 1989 discloses a host material doped with a fluorescent light-emitting dopant (that is, a light-emitting material in which light is emitted via decay of a singlet exciton).

Phosphorescent dopants are also known (that is, a light-emitting dopant in which light is emitted via decay of a triplet exciton).

US2014374727 discloses phosphorescent metal complex for OLEDs of formula (1).

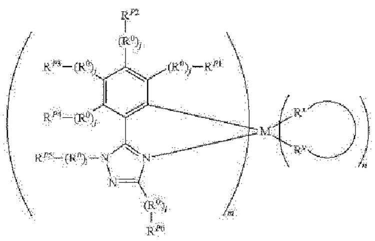

(1)

JP2012222268 discloses phosphorescent metal complex for OLEDs of formula (1-5).

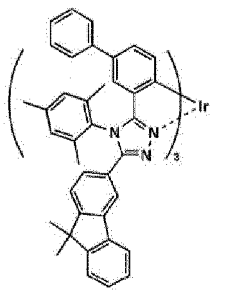

(1-5)

US2012248969 discloses phosphorescent metal complex for OLEDs of formula (G1).

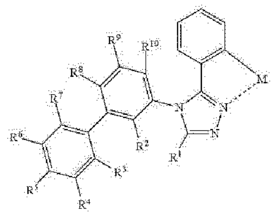

(G1)

US2014151659 discloses phosphorescent metal complex of formula (I).

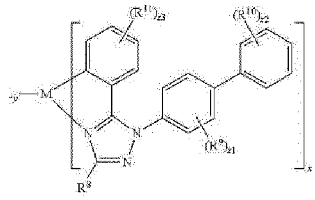

(I)

WO 2011/052516, WO 2014/085296, US 2013/221278 and JP 2011/253980 disclose phosphorescent materials containing phenyltriazole ligands.

It is an object of the invention to provide blue phosphorescent light-emitting compounds suitable for use in an OLED.

It is a further object of the invention to provide solution processable blue phosphorescent light-emitting compounds suitable for use in an OLED.

It is a further objection of the invention to provide phosphorescent light-emitting compounds having long operational life when used in an OLED.

**Summary of the Invention**

In a first aspect the invention provides a phosphorescent compound of formula (Ia):

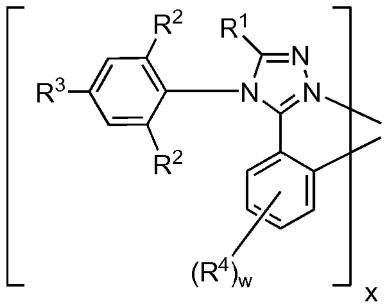

(Ia)

wherein:

M is a transition metal;

L in each occurrence is independently a mono- or poly-dentate ligand;

$R^1$ in each occurrence is independently a branched $C_{3-20}$ alkyl group, a cyclic $C_{5-20}$ alkyl group or group of formula (II):

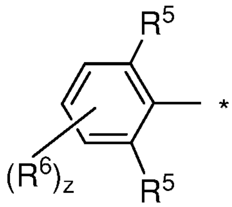

(II)

wherein each $R^5$ is independently a $C_{1-10}$ alkyl group; each $R^6$ is independently a substituent; z is 0 or a positive integer; and * is a point of attachment of the group of formula (II);

$R^2$ independently in each occurrence is a linear, branched or cyclic $C_{1-10}$ alkyl group

$R^3$ independently in each occurrence is a linear, branched or cyclic $C_{1-10}$ alkyl group or a group of formula $-(Ar^1)_p$ wherein $Ar^1$ in each occurrence is independently an aryl or heteroaryl group and p is at least 1;

each $R^4$ is independently a substituent;

w is 1;

x is at least 1; and

y is 0 or a positive integer.

In a second aspect the invention provides a composition comprising a host material and a compound according to the first aspect.

In a third aspect the invention provides a solution comprising a compound or composition according to the first or second aspect dissolved in one or more solvents.

In a fourth aspect the invention provides an organic light-emitting device comprising an anode, a cathode and a light-emitting layer between the anode and cathode wherein the light-emitting layer comprises a compound or composition according to the first or second aspect.

In a fifth aspect the invention provides a method of forming an organic light-emitting device according to the fourth aspect, the method comprising the step of depositing the light-emitting layer over one of the anode and cathode, and depositing the other of the anode and cathode over the light-emitting layer.

## Description of the Drawings

The invention will now be described in more detail with reference to the Figures, in which:

Figure 1 illustrates an OLED according to an embodiment of the invention;

Figure 2 is a graph of luminance vs time for a white OLED according to an embodiment of the invention and a comparative white OLED;

Figure 3 is a graph of brightness vs. time for OLEDs containing materials according to embodiments of the invention; and

Figure 4 is a graph of brightness vs. time for an OLED containing a material according to an embodiment of the invention and an OLED containing a comparative material.

## Detailed Description of the Invention

Figure 1, which is not drawn to any scale, illustrates schematically an OLED 100 according to an embodiment of the invention. The OLED 100 is carried on substrate 107 and comprises an anode 101, a cathode 105 and a light-emitting layer 103 between the anode and the cathode.

One or more further layers (not shown) may be provided between the anode and the cathode including, without limitation, hole-transporting layers, electron-transporting layers, hole-blocking layers, electron-blocking layers, hole-injection layers and electron-injection layers.

Exemplary OLED structures including one or more further layers include the following:

Anode / Hole-injection layer / Light-emitting layer / Cathode

Anode / Hole transporting layer / Light-emitting layer / Cathode

Anode / Hole-injection layer / Hole-transporting layer / Light-emitting layer / Cathode

Anode / Hole-injection layer / Hole-transporting layer / Light-emitting layer / Electron-transporting layer / Cathode

Anode / Hole-injection layer / Hole-transporting layer / Light-emitting layer / Hole-blocking layer / Electron-transporting layer / Cathode.

Preferably, at least one of a hole-transporting layer, hole injection layer, hole-blocking layer and electron-transporting layer is present. Preferably, both a hole injection layer and hole-transporting layer are present.

Light-emitting layer 103 may contain a host material and a phosphorescent compound of formula (Ia). The host material may combine holes injected from the anode and electrons injected from the cathode to form singlet and triplet excitons. The triplet excitons at least may be transferred to the phosphorescent compound of formula (Ia), and decay to produce phosphorescence.

The device may contain more than one light-emitting layer. The light-emitting layer or layers may contain the phosphorescent compound of formula (Ia) and one or more further light-emitting compounds, for example further phosphorescent or fluorescent light-emitting materials having a colour of emission differing from that of the compound of formula (Ia). Optionally, the device comprises a hole-transporting layer and a further light-emitting material is provided in one or both of the hole-transporting layer and the light-emitting layer containing the phosphorescent compound of formula (Ia). Emission from the compound of formula (Ia) and the further light-emitting compounds may produce white light when the device is in use. Optionally, a light-emitting layer comprising a compound of formula (Ia) consists essentially of the compound of formula (Ia), one or more host materials and optionally one or more further light-emitting compounds.

Preferably, light emitted from a composition consisting of a host and a compound of formula (Ia) is substantially all from the compound of formula (Ia).

Phosphorescent Compound

Metal M of the phosphorescent compound of formula (Ia) may be any suitable transition metal, for example a transition metal of the second or third row of the d-block elements (Period 5 and Period 6, respectively, of the Periodic Table). Exemplary metals include Ruthenium, Rhodium, Palladium, Silver, Tungsten, Rhenium, Osmium, Iridium, Platinum and Gold. Preferably, M is iridium.

The compound of formula (Ia) contains at least one ligand of formula:

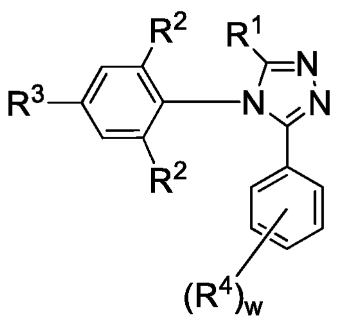

All ligands of the compound of formula (Ia) may have this formula in which case no other ligands L are present (y is 0). In the case where y is 0, x is preferably 3.

In other embodiments, y may be 1 or 2 and x may be 1 or 2. Exemplary ligands L are bidentate ligands and include, without limitation, O,O cyclometallating ligands, optionally diketonates, optionally acac; N,O cyclometallating ligands, optionally picolinate; and N,N cyclometallating ligands.

$R^1$ in each occurrence is independently a branched $C_{3-20}$ alkyl group, a cyclic $C_{5-20}$ alkyl group or group of

formula (II).

The $C_{3-20}$ alkyl group may contain at least one secondary carbon atom or at least one tertiary carbon atom.

In the case where $R^1$ is a branched $C_{3-20}$ alkyl group, the carbon atom of the alkyl group bound to the triazole ring of formula (Ia) is preferably a secondary or tertiary carbon atom.

In the case where $R^1$ is a group of formula (II), z may be 0, 1, 2 or 3. Optionally, z is 0.

In the case where z is 1, 2 or 3, each $R^6$ may independently be selected from the group consisting of F; CN; branched, linear or cyclic $C_{1-20}$ alkyl wherein non-adjacent C atoms of the $C_{1-20}$ alkyl may be replaced with -O-, -S-, $-NR^8-$, $-SiR^8_2-$ or -COO- and one or more H atoms may be replaced with F, wherein $R^8$ is H or a substituent; and a group of formula - $(Ar^1)_p$ wherein $Ar^1$ in each occurrence is independently an aromatic or heteroaromatic group that may be unsubstituted or substituted with one or more substituents and p is at least 1, optionally 1, 2 or 3.

$Ar^1$ may independently in each occurrence be selected from $C_{6-20}$ aryl, optionally phenyl, and $C_{3-20}$ heteroaryl, optionally a heteroaryl containing 3-20 C atoms and one or more heteroatoms selected from O, S and N.

In the case where p is greater than 1, the group $-(Ar^1)_p$ may form a linear or branched chain of $Ar^1$ groups.

Optionally, substituents of $Ar^1$, where present, are selected from the group consisting of branched, linear or cyclic $C_{1-20}$ alkyl wherein one or more non-adjacent C atoms may be replaced with O, S, C=O and -COO-, and wherein one or more H atoms of the $C_{1-20}$ alkyl may be replaced with F. Preferred substituents are selected from branched, linear or cyclic $C_{1-10}$ alkyl.

Exemplary groups of formula $-(Ar^1)_p$ are phenyl; biphenyl; 3,5-diphenylbenzene; and 4,6-diphenyltriazine, each of which may be unsubstituted or substituted with one or more substituents as described above.

$R^8$ may be a $C_{1-40}$ hydrocarbyl group, for example $C_{1-20}$ alkyl, unsubstituted phenyl, and phenyl substituted with one or more $C_{1-20}$ alkyl groups. Preferably, if present $R^6$ is a $C_{1-20}$ alkyl group.

w may be 0, 1, 2 or 3. Preferably, w is 1.

$R^3$ independently in each occurrence is selected from a group of formula $-(Ar^1)_p$ as described above and linear, branched or cyclic $C_{1-10}$ alkyl. Preferably, $R^3$ is selected from $C_{1-10}$ alkyl and $C_{6-20}$ aryl, optionally phenyl, that may be unsubstituted or substituted with one or more $C_{1-10}$ alkyl groups.

Where present, each $R^4$ may independently be selected from the group consisting of F; CN; branched, linear or cyclic $C_{1-20}$ alkyl wherein non-adjacent C atoms of the $C_{1-20}$ alkyl may be replaced with -O-, -S-, $-NR^8-$, $-SiR^8_2-$ or -COO- and one or more H atoms may be replaced with F, wherein $R^8$ is as described above; and a group of formula $-(Ar^1)_p$ as described above.

Preferably, if present $R^3$ and $R^4$ are each independently selected from a linear, branched or cyclic $C_{1-20}$ alkyl group and a group of formula $-(Ar^1)_p$.

Preferred groups $R^3$ and $R^4$ are linear, branched or cyclic $C_{1-20}$ alkyl; unsubstituted phenyl; and phenyl substituted with one or more $C_{1-20}$ alkyl or $C_{1-10}$ alkyl groups.

Optionally, the compound of formula (Ia) has formula (Ib):

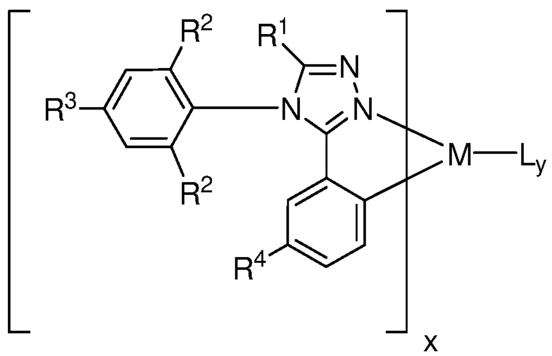

(Ib)

Exemplary compounds of formula (Ia) include the following of which Compound Examples 1 to 6, 8 and 9 do not form part of the invention whereas Compound Examples 7 and 10 to 12 are according to the claimed invention:

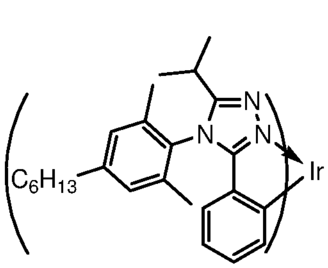

Compound Example 1

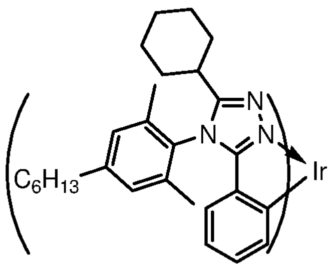

Compound Example 2

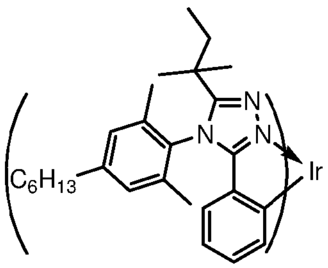

Compound Example 3

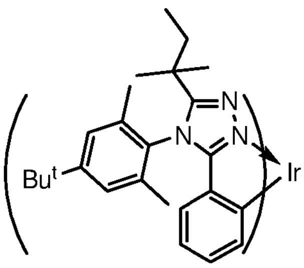

Compound Example 4

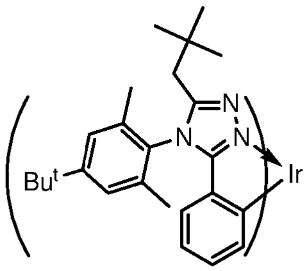

Compound Example 5

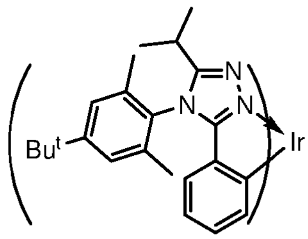

Compound Example 6

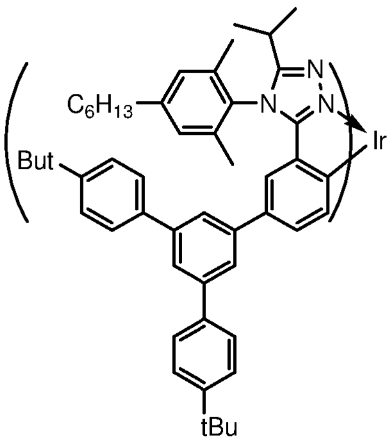

Compound Example 7

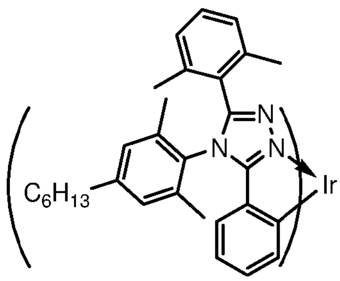

Compound Example 8

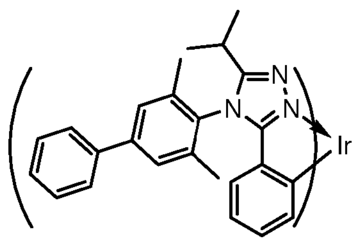

Compound Example 9

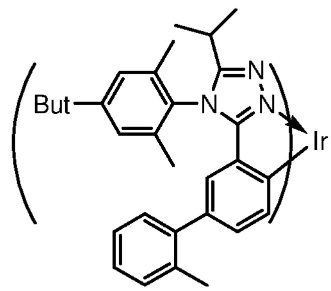

Compound Example 10

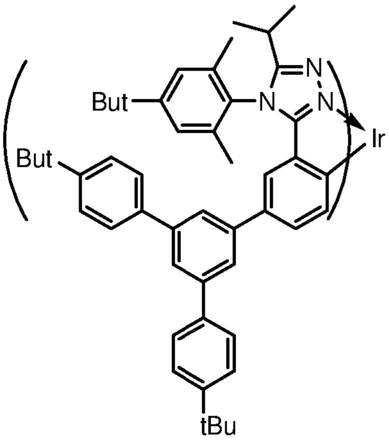

Compound Example 11

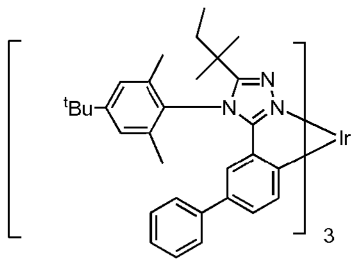

Compound Example 12

Compounds of formula (Ia) preferably have a photoluminescence spectrum with a peak in the range of 400-500 nm, optionally 420-490 nm, optionally 460-480 nm.

The photoluminescence spectrum of a compound of formula (Ia) may be measured by casting 5 wt % of the material in a PMMA film onto a quartz substrate to achieve transmittance values of 0.3-0.4 and measuring in a nitrogen environment using apparatus C9920-02 supplied by Hamamatsu.

Host Material

The host material has a triplet excited state energy level $T_1$ that is no more than 0.1 eV lower than, and preferably at least the same as or higher than, the phosphorescent compound of formula (Ia) in order to allow transfer of triplet excitons from the host material to the phosphorescent compound of formula (Ia).

The triplet excited state energy levels of the host material and the phosphorescent compound may be determined from their respective phosphorescence spectra.. The phosphorescence spectrum of a host material may be determined by the energy onset of the phosphorescence spectrum measured by low temperature phosphorescence spectroscopy (Y.V. Romaovskii et al, Physical Review Letters, 2000, 85 (5), p1027, A.van Dijken et al, Journal of the American Chemical Society, 2004, 126, p7718).

The host material may be a polymer or a non-polymeric compound.

An exemplary non-polymeric host material is an optionally substituted compound of formula (X):

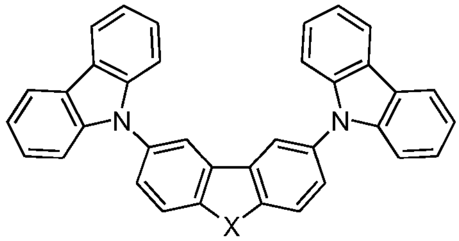

(X)

wherein X is O or S.

Each of the benzene rings of the compound of formula (X) may independently be unsubstituted or substituted with one or more substituents. Substituents may be selected from $C_{1-20}$ alkyl wherein one or more non-adjacent C atoms of the alkyl may be replaced with O, S, COO, C=O or $SiR^8$ wherein the groups $R^8$ are the same or different and are as described above, and one or more H atoms of the alkyl may be replaced with F.

The compound of formula (Ia) may be mixed with the host material or may be covalently bound to the host material. In the case where the host material is a polymer, the metal complex may be provided as a main chain repeat unit, a side group of a repeat unit, or an end group of the polymer.

In the case where the compound of formula (Ia) is provided as a side group, the metal complex may be directly bound to a main chain of the polymer or spaced apart from the main chain by a spacer group. Exemplary spacer groups include $C_{1-20}$ alkyl groups, aryl-$C_{1-20}$ alkyl groups and $C_{1-20}$ alkoxy groups. The polymer main chain or spacer group may be bound to phenyltriazole; or (if present) another ligand of the compound of formula (Ia).

If the compound of formula (Ia) is bound to a polymer comprising conjugated repeat units then it may be bound to the polymer such that there is no conjugation between the conjugated repeat units and the compound of formula (Ia), or such that the extent of conjugation between the conjugated repeat units and the compound of formula (Ia) is limited.

If the compound of formula (Ia) is mixed with a host material then the host: emitter weight ratio may be in the range of 50 - 99.5 : 50 - 0.5.

If the compound of formula (Ia) is bound to a polymer then repeat units or end groups containing a compound of formula (Ia) may form 0.5 - 20 mol percent, more preferably 1 - 10 mol percent of the polymer.

Exemplary host polymers include polymers having a non-conjugated backbone with charge-transporting groups pendant from the non-conjugated backbone, for example poly(9-vinylcarbazole), and polymers comprising conjugated repeat units in the backbone of the polymer. If the backbone of the polymer comprises conjugated repeat units then the extent of conjugation between repeat units in the polymer backbone may be limited in order to maintain a triplet energy level of the polymer that is no lower than that of the phosphorescent compound of formula (Ia).

Exemplary repeat units of a conjugated polymer include unsubstituted or substituted monocyclic and polycyclic heteroarylene repeat units; unsubstituted or substituted monocyclic and polycyclic arylene repeat units as disclosed in for example, Adv. Mater. 2000 12(23) 1737-1750 and include: 1,2-, 1,3- and 1,4-phenylene repeat units as disclosed in J. Appl. Phys. 1996, 79, 934; 2,7-fluorene repeat units as disclosed in EP 0842208; indenofluorene repeat units as disclosed in, for example, Macromolecules 2000, 33(6), 2016-2020; and spirofluorene repeat units as disclosed in, for example EP 0707020. Each of these repeat units is optionally substituted. Examples of substituents include solubilising groups such as $C_{1-20}$ alkyl or alkoxy; electron withdrawing groups such as fluorine, nitro or cyano; and substituents for increasing glass transition temperature (Tg) of the polymer.

One exemplary class of repeat units are unsubstituted or substituted repeat units of formula (IV):

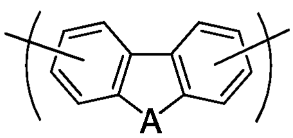

(IV)

wherein A is O, S, $NR^{11}$, $CR^{11}_2$, or $SiR^{11}_2$; $R^{11}$ in each occurrence is the same or different and is H or a substituent, and wherein the two groups $R^{11}$ may be linked to form a ring.

Each $R^{11}$ is preferably a substituent, and each $R^{11}$ may independently be selected from the group consisting of:

$C_{1-20}$ alkyl, wherein one or more non-adjacent C atoms may be replaced with unsubstituted or substituted $C_{5-20}$ aryl or $C_{3-20}$ heteroaryl, optionally phenyl, O, S, substituted N, C=O or -COO-;

a group of formula $-(Ar^6)_r$ wherein each $Ar^6$ is independently an aryl or heteroaryl group, optionally a $C_{5-20}$ aryl or $C_{3-20}$ heteroaryl group, optionally phenyl; r is at least 1; optionally 1, 2 or 3; and $-(Ar^6)_r$ may form a linear or branched chain of $Ar^6$ groups in the case where r is at least 2; and

a crosslinkable-group, for example a group comprising a double bond such and a vinyl or acrylate group, or a benzocyclobutane group.

In the case where $R^{11}$ is $-(Ar^6)_r$, the or each group $Ar^6$ may be unsubstituted or may be substituted with one or more substituents $R^{10}$ selected from the group consisting of:

alkyl, optionally $C_{1-20}$ alkyl, wherein one or more non-adjacent C atoms may be replaced with O, S, substituted N, C=O and -COO- and one or more H atoms of the alkyl group may be replaced with F; and

fluorine, nitro and cyano.

Preferred groups $R^{10}$ are selected from $C_{1-20}$ alkyl.
Aromatic carbon atoms of the repeat unit of formula (IV) may be unsubstituted or substituted with one or more substituents. Substituents may be selected from the group consisting of: alkyl, for example $C_{1-20}$ alkyl, wherein one or more non-adjacent C atoms may be replaced with O, S, substituted N, C=O and -COO-; $C_{5-20}$ aryl that may be unsubstituted or substituted with one or more substituents; $C_{3-20}$ heteroaryl that may be unsubstituted or substituted with one or more substituents; fluorine; and cyano. Particularly preferred substituents include $C_{1-20}$ alkyl and substituted or unsubstituted $C_{5-20}$ aryl, for example phenyl. Optional substituents for the aryl include one or more $C_{1-20}$ alkyl groups.
Where present, substituted N may independently in each occurrence be $NR^{16}$ wherein $R^{16}$ is alkyl, optionally $C_{1-20}$ alkyl, or optionally substituted aryl or heteroaryl, optionally phenyl. Optional substituents for aryl or heteroaryl $R^{16}$ may be selected from $R^{10}$.
Preferably, each $R^{11}$ is selected from the group consisting of $C_{1-20}$ alkyl and optionally substituted phenyl. Optional substituents for phenyl include one or more $C_{1-20}$ alkyl groups.
If the compound of formula (Ia) is provided as a side-chain of the polymer then A may be $NR^{11}$, $CR^{11}_2$, or $SiR^{11}_2$ and at least one $R^{11}$ may comprise a compound of formula (Ia) that is either bound directly to N, C or Si or spaced apart from A by a spacer group.
The extent of conjugation of repeat units of formulae (IV) may be limited by (a) selecting the linking positions of the repeat unit and / or (b) substituting one or more aromatic carbon atoms adjacent to linking positions of the repeat unit in order to create a twist with the adjacent repeat unit or units, for example a 2,7-linked fluorene carrying a $C_{1-20}$ alkyl substituent in one or both of the 3- and 6-positions.
Exemplary repeat units of formula (IV) include the following:

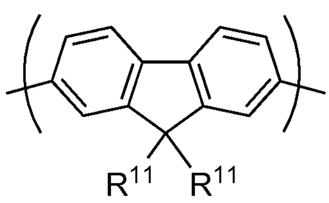
(IVa)

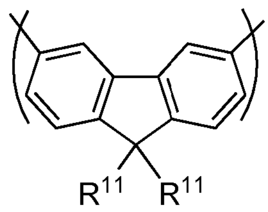
(IVb)

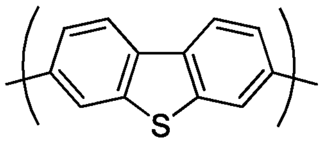 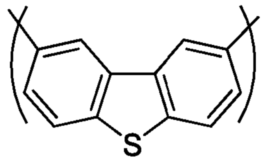

(IVc) (IVd)

A host polymer may contain only one repeat unit of formula (IV) or two or more different repeat units of formula (IV).

Another exemplary class of repeat units is phenylene repeat units, such as phenylene repeat units of formula (V):

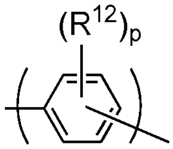

(V)

wherein p is 0, 1, 2, 3 or 4, optionally 1 or 2, and $R^{12}$ independently in each occurrence is a substituent, optionally a substituent $R^{11}$ as described above, for example $C_{1-20}$ alkyl, phenyl that is unsubstituted or substituted with one or more $C_{1-20}$ alkyl groups or a crosslinkable group.

The repeat unit of formula (V) may be 1,4- linked, 1,2-linked or 1,3-linked.

If the repeat unit of formula (V) is 1,4-linked and if p is 0 then the extent of conjugation of repeat unit of formula (V) to one or both adjacent repeat units may be relatively high.

If p is at least 1, and / or the repeat unit is 1,2- or 1,3 linked, then the extent of conjugation of repeat unit of formula (V) to one or both adjacent repeat units may be relatively low. In one preferred arrangement, the repeat unit of formula (V) is 1,3-linked and p is 0, 1, 2 or 3. In another preferred arrangement, the repeat unit of formula (V) has formula (Va):

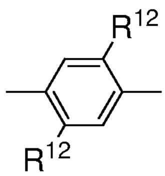

(Va)

Arylene repeat units such as repeat units of formula (IV) and (V) may be fully conjugated with aromatic or heteroaromatic group of adjacent repeat units. Additionally or alternatively, a host polymer may contain a conjugation-breaking repeat unit that completely breaks conjugation between repeat units adjacent to the conjugation-breaking repeat unit. An exemplary conjugation-breaking repeat unit has formula (VI):

$$-(Ar^7\text{-}Sp^1\text{-}Ar^7)- \qquad (VI)$$

wherein $Ar^7$ independently in each occurrence represents an aromatic or heteroaromatic group that may be unsubstituted or substituted with one or more substituents, and $Sp^1$ represents a spacer group comprising at least one $sp^3$ hybridised carbon atom separating the two groups $Ar^7$. Preferably, each $Ar^7$ is phenyl and $Sp^1$ is a $C_{1-10}$ alkyl group. Substituents of

$Ar^7$ may be selected from groups $R^{11}$ described above with reference to formula (IV), and are preferably selected from $C_{1-20}$ alkyl.

A host polymer may comprise charge-transporting units CT that may be hole-transporting units or electron transporting units.

A hole transporting unit may have a low electron affinity (2 eV or lower) and low ionisation potential (5.8 eV or lower, preferably 5.7 eV or lower, more preferred 5.6 eV or lower).

An electron-transporting unit may have a high electron affinity (1.8 eV or higher, preferably 2 eV or higher, even more preferred 2.2 eV or higher) and high ionisation potential (5.8 eV or higher) Suitable electron transport groups include groups disclosed in, for example, Shirota and Kageyama, Chem. Rev. 2007, 107, 953-1010.

Electron affinities and ionisation potentials may be measured by cyclic voltammetry (CV). The working electrode potential may be ramped linearly versus time.

When cyclic voltammetry reaches a set potential the working electrode's potential ramp is inverted. This inversion can happen multiple times during a single experiment. The current at the working electrode is plotted versus the applied voltage to give the cyclic voltammogram trace.
Apparatus to measure HOMO or LUMO energy levels by CV may comprise a cell containing a tert-butyl ammonium perchlorate/ or tertbutyl ammonium hexafluorophosphate solution in acetonitrile, a glassy carbon working electrode where the sample is coated as a film, a platinium counter electrode (donor or acceptor of electrons) and a reference glass electrode no leak Ag/AgCl. Ferrocene is added in the cell at the end of the experiment for calculation purposes. (Measurement of the difference of potential between Ag/AgCl/ferrocene and sample/ferrocene).

Method and settings:

3mm diameter glassy carbon working electrode
Ag/AgCl/no leak reference electrode
Pt wire auxiliary electrode
0.1 M tetrabutylammonium hexafluorophosphate in acetonitrile

$$\text{LUMO} = 4.8 - \text{ferrocene (peak to peak maximum average)} + \text{onset}$$

Sample: 1 drop of 5mg/mL in toluene spun @3000rpm LUMO (reduction) measurement:
A good reversible reduction event is typically observed for thick films measured at 200 mV/s and a switching potential of -2.5V. The reduction events should be measured and compared over 10 cycles, usually measurements are taken on the 3rd cycle. The onset is taken at the intersection of lines of best fit at the steepest part of the reduction event and the baseline.

Exemplary hole-transporting repeat units have formula (IX):

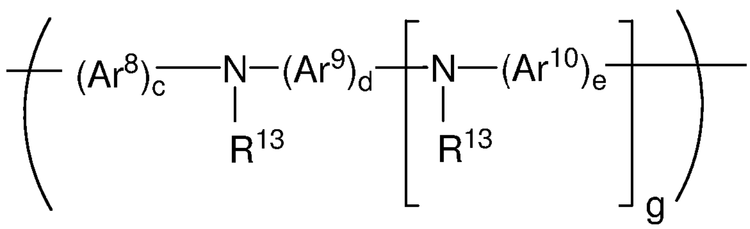

(IX)

wherein $Ar^8$, $Ar^9$ and $Ar^{10}$ in each occurrence are independently selected from substituted or unsubstituted aryl or heteroaryl, g is 0, 1 or 2, preferably 0 or 1, $R^{13}$ independently in each occurrence is H or a substituent, preferably a substituent, and c, d and e are each independently 1, 2 or 3.

$R^{13}$, which may be the same or different in each occurrence when g is 1 or 2, is preferably selected from the group consisting of alkyl, for example $C_{1-20}$ alkyl, $Ar^{11}$ and a branched or linear chain of $Ar^{11}$ groups wherein $Ar^{11}$ in each occurrence is independently substituted or unsubstituted aryl or heteroaryl.

Any two aromatic or heteroaromatic groups selected from $Ar^8$, $Ar^9$, and, if present, $Ar^{10}$ and $Ar^{11}$ that are directly bound to the same N atom may be linked by a direct bond or a divalent linking atom or group. Preferred divalent linking atoms and groups include O, S; substituted N; and substituted C.

$Ar^8$ and $Ar^{10}$ are preferably $C_{6-20}$ aryl, more preferably phenyl, that may be unsubstituted or substituted with one or more substituents.

In the case where g = 0, $Ar^9$ is preferably $C_{6-20}$ aryl, more preferably phenyl, that may be unsubstituted or substituted with one or more substituents.

In the case where g = 1, $Ar^9$ is preferably $C_{6-20}$ aryl, more preferably phenyl or a polycyclic aromatic group, for example naphthalene, perylene, anthracene or fluorene, that may be unsubstituted or substituted with one or more substituents.

$R^{13}$ is preferably $Ar^{11}$ or a branched or linear chain of $Ar^{11}$ groups. $Ar^{11}$ in each occurrence is preferably phenyl that may be unsubstituted or substituted with one or more substituents.

Exemplary groups $R^{13}$ include the following, each of which may be unsubstituted or substituted with one or more substituents, and wherein * represents a point of attachment to N:

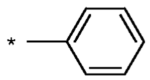
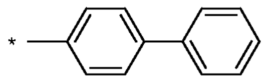
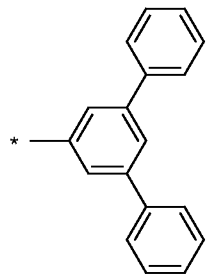
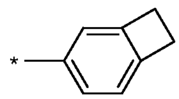

c, d and e are preferably each 1.

$Ar^8$, $Ar^9$, and, if present, $Ar^{10}$ and $Ar^{11}$ are each independently unsubstituted or substituted with one or more, optionally 1, 2, 3 or 4, substituents. Optionally, substituents are selected from substituted or unsubstituted alkyl, optionally $C_{1-20}$ alkyl, wherein one or more non-adjacent C atoms may be replaced with optionally substituted aryl or heteroaryl (preferably phenyl), O, S, C=O or -COO- and one or more H atoms may be replaced with F.

Preferred substituents of $Ar^8$, $Ar^9$, and, if present, $Ar^{10}$ and $Ar^{11}$ are $C_{1-40}$ hydrocarbyl, preferably $C_{1-20}$ alkyl.

Preferred repeat units of formula (IX) include unsubstituted or substituted units of formulae (IX-1), (IX-2) and (IX-3):

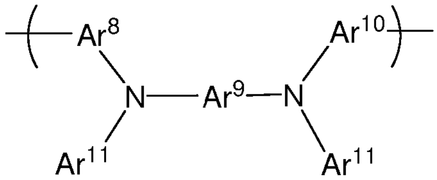

**1**

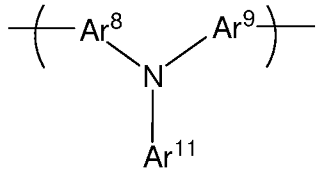

**2**

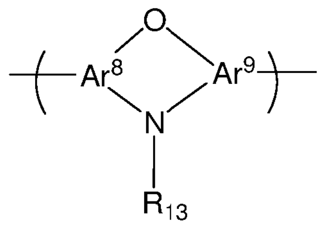

**3**

Triazines form an exemplary class of electron-transporting units, for example optionally substituted di-or tri-(hetero)aryltriazine attached as a side group through one of the (hetero)aryl groups. Other exemplary electron-transporting units are pyrimidines and pyridines; sulfoxides and phosphine oxides; benzophenones; and boranes, each of which may be unsubstituted or substituted with one or more substituents, for example one or more $C_{1-20}$ alkyl groups.

Exemplary electron-transporting units CT have formula (VII):

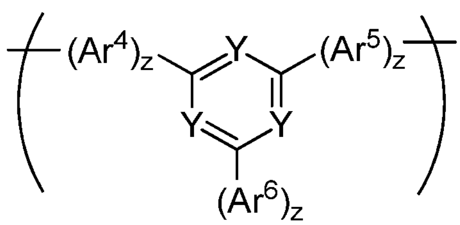

(VII)

wherein $Ar^4$, $Ar^5$ and $Ar^6$ are in each occurrence are independently selected from substituted or unsubstituted aryl or heteroaryl; z in each occurrence is independently at least 1, optionally 1, 2 or 3; and Y is N or $CR^7$, wherein $R^7$ is H or a substituent, preferably H or $C_{1-10}$ alkyl... Where present, substituents of $Ar^4$, $Ar^5$ and $Ar^6$ are each independently

selected from substituted or unsubstituted alkyl, optionally $C_{1-20}$ alkyl, wherein one or more non-adjacent C atoms may be replaced with optionally substituted aryl or heteroaryl (preferably phenyl), O, S, C=O or -COO- and one or more H atoms may be replaced with F. Preferably, $Ar^4$, $Ar^5$ and $Ar^6$ of formula (VII) are each phenyl, each phenyl being optionally and independently substituted with one or more $C_{1-20}$ alkyl groups.

In one preferred embodiment, all 3 groups Y are N.

If all 3 groups Y are $CR^7$ then at least one of $Ar^4$, $Ar^5$ and $Ar^6$ is preferably a heteroaromatic group comprising N.

In one arrangement, $Ar^4$, $Ar^5$ and $Ar^6$ are phenyl in each occurrence.

$Ar^6$ of formula (VII) is preferably phenyl, and is optionally substituted with one or more $C_{1-20}$ alkyl groups or a crosslinkable unit.

The charge-transporting units CT may be provided as distinct repeat units formed by polymerising a corresponding monomer. Alternatively, the one or more CT units may form part of a larger repeat unit, for example a repeat unit of formula (VIII):

$$\left( (Ar^3)_q - Sp - CT - Sp - (Ar^3)_q \right)$$

(VIII)

wherein CT represents a conjugated charge-transporting group; each $Ar^3$ independently represents an unsubstituted or substituted aryl or heteroaryl; q is at least 1; and each Sp independently represents a spacer group forming a break in conjugation between $Ar^3$ and CT.

Sp is preferably a branched, linear or cyclic $C_{1-20}$ alkyl group.

Exemplary CT groups include units of formula (IX) or (VII) described above.

$Ar^3$ is preferably an unsubstituted or substituted aryl, optionally an unsubstituted or substituted phenyl or fluorene. Optional substituents for $Ar^3$ may be selected from $R^8$ as described above, and are preferably selected from one or more $C_{1-20}$ alkyl substituents.

q is preferably 1.

## White OLED

An OLED of the invention may be a white OLED containing a blue light-emitting compound of formula (Ia) and one or more further light-emitting materials having a colour of emission such that light emitted from the device is white. Further light-emitting materials include red and green light-emitting materials that may be fluorescent or phosphorescent. Optionally, all light emitted from a white OLED is phosphorescence.

The one or more further light-emitting materials may present in the same light-emitting layer as the compound of formula (Ia) or may be provided in one or more further light-emitting layers of the device. In one optional arrangement an OLED may comprise a red light-emitting layer and a green and blue light-emitting layer. Optionally, the red layer is a hole-transporting layer that is adjacent to the green and blue light-emitting layer.

The light emitted from a white OLED may have CIE x coordinate equivalent to that emitted by a black body at a temperature in the range of 2500-9000K and a CIE y coordinate within 0.05 or 0.025 of the CIE y co-ordinate of said light emitted by a black body, optionally a CIE x coordinate equivalent to that emitted by a black body at a temperature in the range of 2700-600K.

A green emitting material may have a photoluminescent spectrum with a peak in the range of more than 500 nm up to 580 nm, optionally more than 490 nm up to 540 nm

A red emitting material may optionally have a peak in its photoluminescent spectrum of more than 580 nm up to 630 nm, optionally 585 nm up to 625 nm.

## Polymer synthesis

Preferred methods for preparation of conjugated polymers, such as polymers comprising one or more of repeat units of formulae (IV), (V), (VI), (VII), (VIII) and (IX) as described above, comprise a "metal insertion" wherein the metal atom of a metal complex catalyst is inserted between an aryl or heteroaryl group and a leaving group of a monomer. Exemplary metal insertion methods are Suzuki polymerisation as described in, for example, WO 00/53656 and Yamamoto polymerisation as described in, for example, T. Yamamoto, "Electrically Conducting And Thermally Stable pi-Conjugated Poly(arylene)s Prepared by Organometallic Processes", Progress in Polymer Science 1993, 17, 1153-1205. In the case of Yamamoto polymerisation, a nickel complex catalyst is used; in the case of Suzuki polymerisation, a palladium complex

catalyst is used.

For example, in the synthesis of a linear polymer by Yamamoto polymerisation, a monomer having two reactive halogen groups is used. Similarly, according to the method of Suzuki polymerisation, at least one reactive group is a boron derivative group such as a boronic acid or boronic ester and the other reactive group is a halogen. Preferred halogens are chlorine, bromine and iodine, most preferably bromine.

It will therefore be appreciated that repeat units illustrated throughout this application may be derived from a monomer carrying suitable leaving groups. Likewise, an end group or side group may be bound to the polymer by reaction of a suitable leaving group.

Suzuki polymerisation may be used to prepare regioregular, block and random copolymers. In particular, homopolymers or random copolymers may be prepared when one reactive group is a halogen and the other reactive group is a boron derivative group. Alternatively, block or regioregular copolymers may be prepared when both reactive groups of a first monomer are boron and both reactive groups of a second monomer are halogen.

As alternatives to halides, other leaving groups capable of participating in metal insertion include sulfonic acids and sulfonic acid esters such as tosylate, mesylate and triflate.

Charge transporting and charge blocking layers

A hole transporting layer may be provided between the anode and the light-emitting layer or layers. Likewise, an electron transporting layer may be provided between the cathode and the light-emitting layer or layers.

Similarly, an electron blocking layer may be provided between the anode and the light-emitting layer and a hole blocking layer may be provided between the cathode and the light-emitting layer. Transporting and blocking layers may be used in combination. Depending on its HOMO and LUMO levels, a single layer may both transport one of holes and electrons and block the other of holes and electrons.

A charge-transporting layer or charge-blocking layer may be crosslinked, particularly if a layer overlying that charge-transporting or charge-blocking layer is deposited from a solution. The crosslinkable group used for this crosslinking may be a crosslinkable group comprising a reactive double bond such and a vinyl or acrylate group, or a benzocyclobutane group. The crosslinkable group may be provided as a substituent pendant from the backbone of a charge-transporting or charge-blocking polymer. Following formation of a charge-transporting or charge blocking layer, the crosslinkable group may be crosslinked by thermal treatment or irradiation.

If present, a hole transporting layer located between the anode and the light-emitting layers preferably has a HOMO level of less than or equal to 5.5 eV, more preferably around 4.8-5.5 eV as measured by cyclic voltammetry. The HOMO level of the hole transport layer may be selected so as to be within 0.2 eV, optionally within 0.1 eV, of an adjacent layer (such as a light-emitting layer) in order to provide a small barrier to hole transport between these layers.

If present, an electron transporting layer located between the light-emitting layers and cathode preferably has a LUMO level of around 2.5-3.5 eV as measured by square wave cyclic voltammetry. A layer of a silicon monoxide or silicon dioxide or other thin dielectric layer having thickness in the range of 0.2-2 nm may be provided between the light-emitting layer nearest the cathode and the cathode. HOMO and LUMO levels may be measured using cyclic voltammetry.

If present, a hole-blocking layer may comprise or consist of a compound of formula (XII):

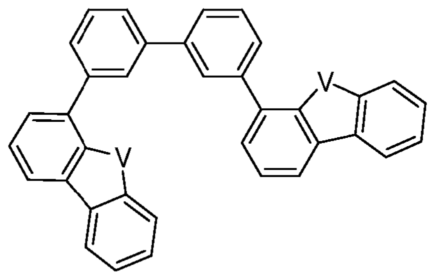

(XII)

wherein V in each occurrence is independently S or O, preferably S. The compound of formula (XII) may be unsubstituted or may be substituted with one or more substituents, optionally one or more $C_{1-40}$ hydrocarbyl groups, optionally one or more $C_{1-20}$ alkyl groups.

A hole transporting layer may contain a hole-transporting (hetero)arylamine, such as a homopolymer or copolymer comprising hole transporting repeat units of formula (IX). Exemplary copolymers comprise repeat units of formula (IX) and optionally substituted (hetero)arylene co-repeat units, such as phenyl, fluorene or indenofluorene repeat units

as described above, wherein each of said (hetero)arylene repeat units may optionally be substituted with one or more substituents such as alkyl or alkoxy groups. Specific co-repeat units include fluorene repeat units of formula (IVa) and phenylene repeat units of formula (V) as described above. A hole-transporting copolymer containing repeat units of formula (IX) may contain 25-95 mol % of repeat units of formula (IX).

An electron transporting layer may contain a polymer comprising a chain of optionally substituted arylene repeat units, such as a chain of fluorene repeat units.

More than one hole-transporting layer or more than one electron-transporting layer may be provided. In an embodiment, two or more hole-transporting layers are provided.

## Hole injection layers

A conductive hole injection layer, which may be formed from a conductive organic or inorganic material, may be provided between the anode and the light-emitting layer or layers to assist hole injection from the anode into the layer or layers of semiconducting polymer. A hole transporting layer may be used in combination with a hole injection layer.

Examples of doped organic hole injection materials include optionally substituted, doped poly(ethylene dioxythiophene) (PEDT), in particular PEDT doped with a charge-balancing polyacid such as polystyrene sulfonate (PSS) as disclosed in EP 0901176 and EP 0947123, polyacrylic acid or a fluorinated sulfonic acid, for example Nafion ®; polyaniline as disclosed in US 5723873 and US 5798170; and optionally substituted polythiophene or poly(thienothiophene). Examples of conductive inorganic materials include transition metal oxides such as VOx, MoOx and RuOx as disclosed in Journal of Physics D: Applied Physics (1996), 29(11), 2750-2753.

## Cathode

The cathode is selected from materials that have a workfunction allowing injection of electrons into the light-emitting layer or layers. Other factors influence the selection of the cathode such as the possibility of adverse interactions between the cathode and the light-emitting materials. The cathode may consist of a single material such as a layer of aluminium. Alternatively, it may comprise a plurality of metals, for example a bilayer of a low workfunction material and a high workfunction material such as calcium and aluminium as disclosed in WO 98/10621. The cathode may contain a layer containing elemental barium, for example as disclosed in WO 98/57381, Appl. Phys. Lett. 2002, 81(4), 634 and WO 02/84759. The cathode may contain a thin (e.g. 1-5 nm thick) layer of metal compound between the light-emitting layer(s) of the OLED and one or more conductive layers of the cathode, such as one or more metal layers. Exemplary metal compounds include an oxide or fluoride of an alkali or alkali earth metal, to assist electron injection, for example lithium fluoride as disclosed in WO 00/48258; barium fluoride as disclosed in Appl. Phys. Lett. 2001, 79(5), 2001; and barium oxide. In order to provide efficient injection of electrons into the device, the cathode preferably has a workfunction of less than 3.5 eV, more preferably less than 3.2 eV, most preferably less than 3 eV. Work functions of metals can be found in, for example, Michaelson, J. Appl. Phys. 48(11), 4729, 1977.

The cathode may be opaque or transparent. Transparent cathodes are particularly advantageous for active matrix devices because emission through a transparent anode in such devices is at least partially blocked by drive circuitry located underneath the emissive pixels. A transparent cathode comprises a layer of an electron injecting material that is sufficiently thin to be transparent. Typically, the lateral conductivity of this layer will be low as a result of its thinness. In this case, the layer of electron injecting material is used in combination with a thicker layer of transparent conducting material such as indium tin oxide.

It will be appreciated that a transparent cathode device need not have a transparent anode (unless, of course, a fully transparent device is desired), and so the transparent anode used for bottom-emitting devices may be replaced or supplemented with a layer of reflective material such as a layer of aluminium. Examples of transparent cathode devices are disclosed in, for example, GB 2348316.

## Encapsulation

Organic optoelectronic devices tend to be sensitive to moisture and oxygen. Accordingly, the substrate 1 preferably has good barrier properties for prevention of ingress of moisture and oxygen into the device. The substrate is commonly glass, however alternative substrates may be used, in particular where flexibility of the device is desirable. For example, the substrate may comprise a plastic as in US 6268695 which discloses a substrate of alternating plastic and barrier layers or a laminate of thin glass and plastic as disclosed in EP 0949850.

The device may be encapsulated with an encapsulant (not shown) to prevent ingress of moisture and oxygen. Suitable encapsulants include a sheet of glass, films having suitable barrier properties such as silicon dioxide, silicon monoxide, silicon nitride or alternating stacks of polymer and dielectric as disclosed in, for example, WO 01/81649 or an airtight container as disclosed in, for example, WO 01/19142. In the case of a transparent cathode device, a transparent

encapsulating layer such as silicon monoxide or silicon dioxide may be deposited to micron levels of thickness, although in one preferred embodiment the thickness of such a layer is in the range of 20-300 nm. A getter material for absorption of any atmospheric moisture and / or oxygen that may permeate through the substrate or encapsulant may be disposed between the substrate and the encapsulant.

Solution processing

Suitable solvents for forming solution processable formulations of the light-emitting metal complex of formula (Ia) and compositions thereof may be selected from common organic solvents, such as mono- or poly-alkylbenzenes such as toluene and xylene and mono- or poly-alkoxybenzenes, and mixtures thereof. The formulation may comprise one or more solvents.

The formulation may comprise the compound of formula (Ia) dissolved in the solvent or solvents and, optionally, one or more further materials dissolved or dispersed, preferably dissolved, in the solvent or solvents.

The one or more further materials may comprise or consist of one or more of a host material and one or more further light-emitting materials.

Exemplary solution deposition techniques for forming a light-emitting layer containing a compound of formula (Ia) include printing and coating techniques such spin-coating, dip-coating, roll-to-roll coating or roll-to-roll printing, doctor blade coating, slot die coating, gravure printing, screen printing and inkjet printing.

Coating methods, such as those described above, are particularly suitable for devices wherein patterning of the light-emitting layer or layers is unnecessary - for example for lighting applications or simple monochrome segmented displays.

Printing is particularly suitable for high information content displays, in particular full colour displays. A device may be inkjet printed by providing a patterned layer over the first electrode and defining wells for printing of one colour (in the case of a monochrome device) or multiple colours (in the case of a multicolour, in particular full colour device). The patterned layer is typically a layer of photoresist that is patterned to define wells as described in, for example, EP 0880303.

As an alternative to wells, the ink may be printed into channels defined within a patterned layer. In particular, the photoresist may be patterned to form channels which, unlike wells, extend over a plurality of pixels and which may be closed or open at the channel ends.

The same coating and printing methods may be used to form other layers of an OLED including (where present) a hole injection layer, a charge transporting layer and a charge blocking layer.

**Examples**

Compound Example 1

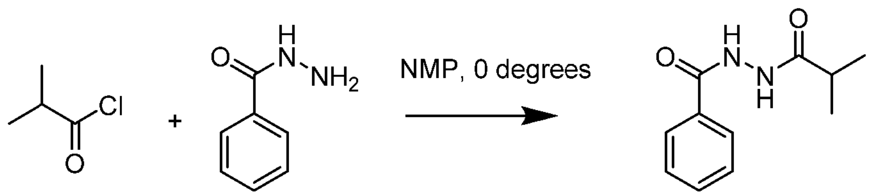


*Stage 1*: Benzhydrazide (25.99g, 190.9mmol) was placed in a flask under a nitrogen atmosphere and dissolved in 120mL N-methyl-2-pyrrolidone (NMP). The solution was stirred and cooled in an ice bath and a mixture of 20mL (20.34g, 190.9mmol) isobutyryl chloride and 30mL NMP was added dropwise. After addition was complete the reaction was warmed to room temperature and stirred for 18hr.

The reaction mixture was poured into 1.2L water and the aqueous mixture was extracted with 2 x 600mL ethyl acetate. The combined organic solutions were dired over $MgSO_4$, filtered and concentrated. Residual NMP was removed from the crude mixture by trituration with cold toluene and the product collected by filtration giving a white crystalline solid, 22.45g, 57% yield.

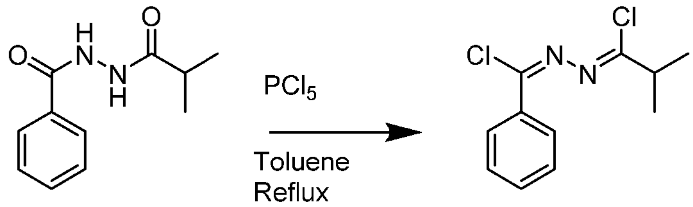


*Stage 2*: Stage 1 (22.0g, 104.9mmol) was placed in a flask under nitrogen and dissolved in 350mL dry toluene. The reaction was stirred at room temperature and $PCl_5$ (44.6g, 209.8mmol) was added portionwise as a solid through a flow of nitrogen. The reaction was heated at 110°C for 4hr. After cooling to room temperature, the reaction mixture was poured into 400mL ice water and stirred for 1hr. The organic phase was separated and washed with 200mL $NaHCO_3$ (10% aq) and 200mL brine then dried over $MgSO_4$, filtered and concentrated. Some benzyl chloride by-product was removed by distillation and the resulting oil was used without further purification. Product identified by GCMS (m/z = 242)

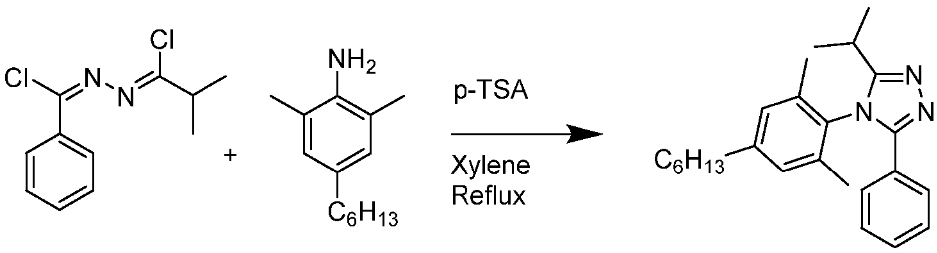


*Stage 3*: Stage 2 (15.0g, 61.7mmol) and 2,6-dimethyl-4-n-hexylaniline (13.94g, 67.86mmol) were placed in a flask and dissolved in 100mL xylene. Para-toluenesulfonic acid (p-TSA) (0.6g, 3.15mmol) was added and the reaction heated at 125°C for 64hr. An addional 0.6g p-TSA was added halfway through the reaction time. The reaction was cooled to room temperature and 100mL water was added and the mixture stirred for 1hr. The organic phase was separated and washed with 100mL $NaHCO_3$ (5% aq), dried over $MgSO_4$, filtered and concentrated giving a light brown oil. The crude was purified by column chromatography on Silica with a mixture or heptane and ethyl acetate. Further purification by recrystallisation with heptane/ethyl actetate gave 8.7g white crystalline solid. 48% yield.

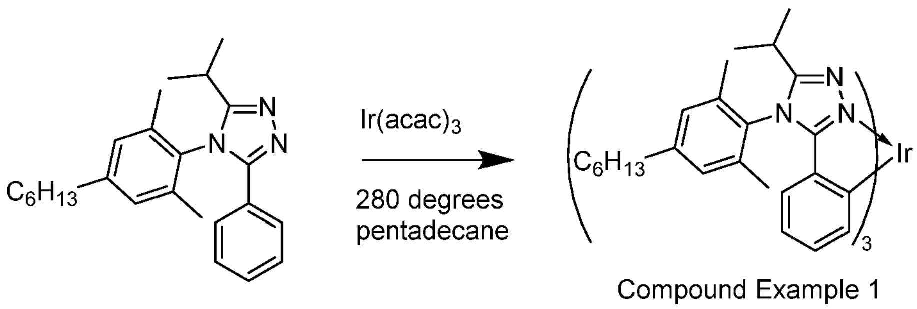


Compound Example 1

*Synthesis of Compound Example 1 (not according to the invention)*: Stage 3 (1.84g, 4.90mmol) and iridium(III) acetylacetonate (0.60g, 1.23mmol) were placed in a flask put under an inert atmosphere by pumping and backfilling with nitrogen. 2mL pentadecane was degassed by bubbling with nitrogen for 20min then added to the reaction flask. The mixture was heated at 280°C and the resulting melt was stirred for 41hr. Cooling to room temperature gave a yellow/brown glassy solid which was purified by column chromatography on silica eluted with mixed heptane/ethyl acetate. Further purification by recrystallisation in heptane/toluene gave 0.44g yellow solid, 99.80% HPLC purity. 27% yield.

Compound Example 2-6, 8 and 9 are useful for understanding the invention but are not covered by the claims. Compound Examples 7 and 10-12 are according to the claimed invention.

Compound Example 2-8 and 12 were formed by a method analogous to that of Compound Example 1.

Compound Examples 2-8

Compound Example 2: Yield 0.19g, 98.86% purity
Compound Example 3: Yield 1.08g, 99.65% purity
Compound Example 4: Yield 1.02g, 99.82% purity
Compound Example 5: Yield 1.76g, 99.81% purity
Compound Example 6: Yield 1.11g, 99.84% purity
Compound Example 7: Yield 0.28g, 95.30% purity
Compound Example 8: Yield 0.58g, 99.23% purity

Compound Example 11

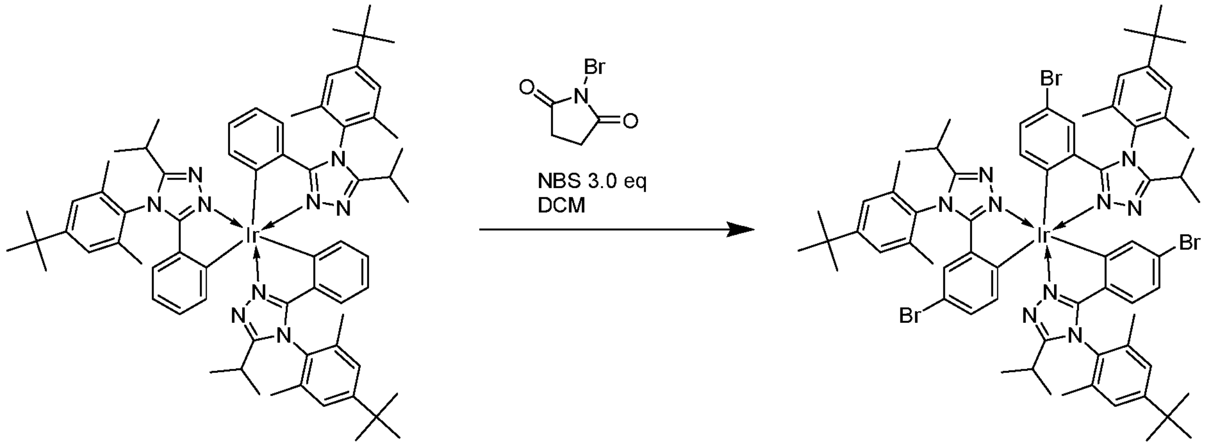


*Stage 1:*

Compound Example 6 (2.20g, 1.79 mmol) was dissolved in dichloromethane (30 mL) in a flask and purged with nitrogen. The solution was cooled to 0°C, and N-bromosuccinimide (0.950 g, 5.36 mmol) was added portion-wise over 15min. The reaction was allowed to warm slowly to room temperature and stirred for 20hr. The reaction was then quenched by addition of 100mL methanol. After 15min stirring, the yellow precipitate was collected by filtration and washed with methanol. Yield, 2.13g (81%), 99.28% HPLC purity; LCMS (ES+): m/z 1468 ($[M+H]^+$), 1506 ($[M+K]^+$)

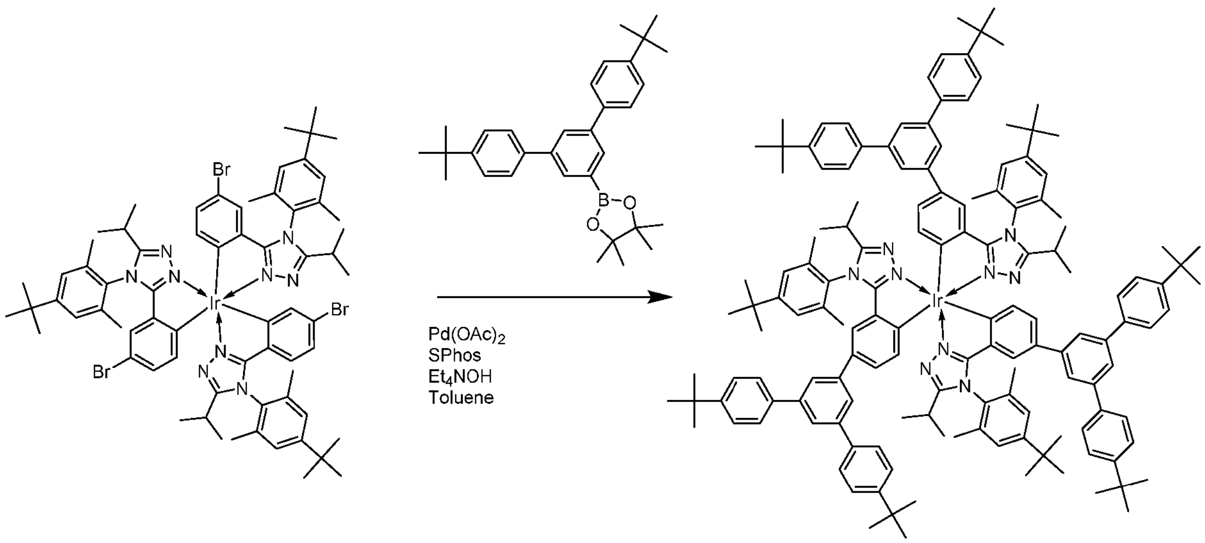


*Stage 2*:

The product from stage 2 (1g, 0.681 mmol) and 3,5-di(4-t-butylphenyl)benzene boronic acid pinacol ester (1.1g,

2.35 mmol) were dissolved in 50mL toluene and degassed by bubbling with nitrogen for 40 min. $Pd_2(dba)_3$ (0.0094g, 0.0102 mmol) and SPhos (0.0084, 0.0204 mmol) were added as solids, and the mixture bubbled with nitrogen for a further 5 min. Separately, 1.8mL $Et_4NOH$ (20%aq) solution (4.09 mmol) was bubbled with nitrogen for 1hr. The reaction was heated to 90°C and the base solution was added then the temperature increased to 110°C. The reaction was stirred at this temperature for 20hr. After cooling to room temperature, the aqueous part was discarded from the reaction mixture and the organic solution was filtered through a plug of silica, eluted with ethyl acetate. Evaporation of the solvent gave the crude product as a yellow solid. HPLC/LCMS analysis showed the presence of residual (10%) partially coupled bromide intermediate, so the above procedure was repeated using 0.064g of boronic ester. The resulting new crude was purified by column chromatography on silica (eluting with mixtures of dichlormethane and ethyl acetate) and recrystallization from mixtures of toluene and acetonitrile. Yield 0.716g (47%) at 99.6% HPLC purity.

Device Example 1 (not according to the invention)

A white organic light-emitting device having the following structure was prepared:

ITO / HIL / HTL / LEL / ETL / Cathode

wherein ITO is an indium-tin oxide anode; HIL is a hole-injecting layer comprising a hole-injecting material, HTL is a hole-transporting layer, LEL is a light-emitting layer containing light-emitting metal complexes and a host polymer, and ETL is an electron-transporting layer.

A substrate carrying ITO was cleaned using UV / Ozone. A hole injection layer was formed to a thickness of about 35 nm by spin-coating an aqueous formulation of a hole-injection material available from Nissan Chemical Industries and heating the resultant layer.

A red-emitting hole transporting layer was formed to a thickness of about 20 nm by spin-coating a crosslinkable red-emitting hole-transporting polymer and crosslinking the polymer by heating.

A green and blue light emitting layer was formed by depositing a light-emitting composition containing Host 1 doped with Compound Example 1 (blue light-emitting metal complex) and a green phosphorescent tris(phenylpyridine)iridium emitter wherein each ligand is substituted with an alkylated 3,5-diphenylbenzene dendron in a weight ratio of Host 1 : Compound Example 1 : green phosphorescent emitter of 74 : 25 : 1) to a thickness of about 75 nm by spin-coating. An electron-transporting layer was formed by depositing an electron-transporting polymer comprising Electron-Transporting Unit 1 as described in WO 2012/133229 to a thickness of 10 nm.

A cathode was formed by evaporation of a first layer of a sodium fluoride to a thickness of about 2 nm, a second layer of aluminium to a thickness of about 100 nm and a third layer of silver to a thickness of about 100 nm.

Host 1 has formula:

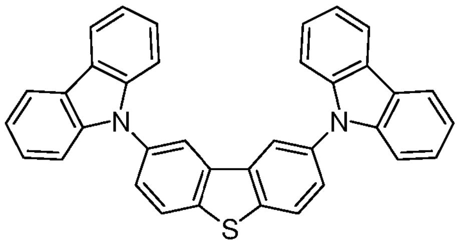

The red-emitting hole transporting polymer was formed by Suzuki polymerisation as described in WO 00/53656 to give a polymer comprising crosslinkable phenylene repeat units of formula (Va); amine repeat units of formula (IX-1) and a 3 mol % of a red phosphorescent group of formula:

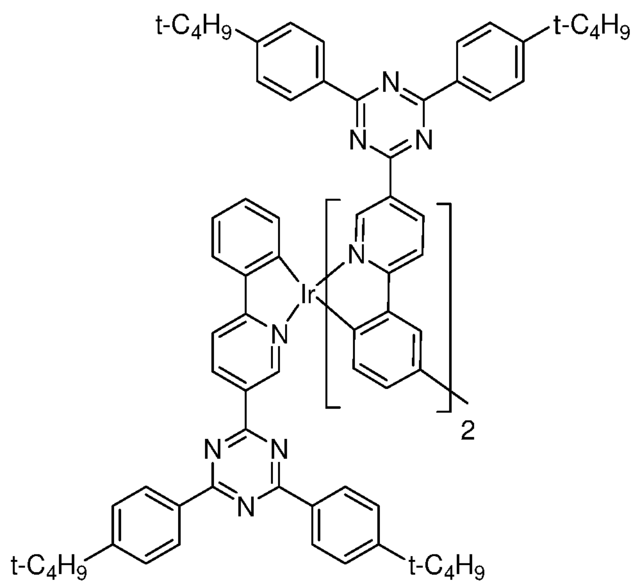

Electron-Transporting Unit 1 has formula:

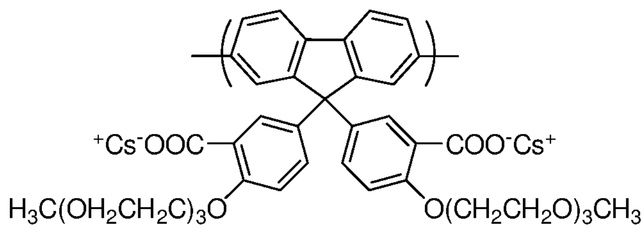

Comparative Device 1

A device was prepared as described in Device Example 1 except that Compound Example 1 was replaced with Comparative Emitter 1:

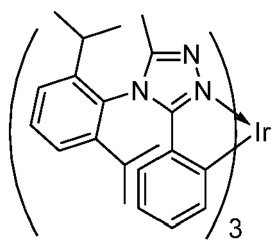

Comparative Emitter 1

With reference to Figure 2, the time taken for brightness of Device Example 1 (dotted line) to fall to 70 % of an initial brightness was several times that of Comparative Device 1 (solid line).

Device Example 2 (not according to the invention)

A device was prepared as described for Device Example 1 except that Compound Example 1 was replaced with Compound Example 6.

Device Example 3

A device was prepared as described for Device Example 2 except that Compound Example 6 was replaced

with Compound Example 11.

Figure 3 is a graph of luminance vs. time for Device Example 2 (Compound Example 6) and Device Example 3 (Compound Example 11).

Device Example 4

A white organic light-emitting device having the following structure was prepared:

ITO / HIL / LEL (R) / LEL (G, B) / HBL / ETL / Cathode

wherein ITO is an indium-tin oxide anode; HIL is a hole-injecting layer comprising a hole-injecting material, LEL (R) is a red light-emitting hole-transporting layer, LEL (G, B) is a green and blue light-emitting layer, HBL is a hole-blocking layer; and ETL is an electron-transporting layer.

A substrate carrying ITO (45 nm) was cleaned using UV / Ozone. A hole injection layer was formed to a thickness of about 35 nm by spin-coating a formulation of a hole-injection material available from Nissan Chemical Industries. A red light-emitting layer was formed to a thickness of about 20 nm by spin-coating the red-emitting hole-transporting polymer described in Device Example 1, and crosslinking the polymer by heating at 180°C. The green and blue light-emitting layer was formed to a thickness of about 70 nm by spin-coating Compound Example A (74 wt %), a green phosphorescent emitter (1 wt %) and Compound Example 12 (24 wt %) wherein the green phosphorescent emitter is a tris(phenylpyridine)iridium emitter wherein each phenylpyridine ligand is substituted with an alkylated 3,5-diphenylbenzene dendron. A hole-blocking layer of Hole Blocking Compound 1 was evaporated onto the light-emitting layer to a thickness of 10 nm. An electron-transporting layer was formed by spin-coating a polymer comprising Electron-Transporting Unit 1 to a thickness of 10 nm. A cathode was formed on the electron-transporting layer of a first layer of sodium fluoride of about 3.5 nm thickness, a layer of aluminium of about 100 nm thickness and a layer of silver of about 100 nm thickness.

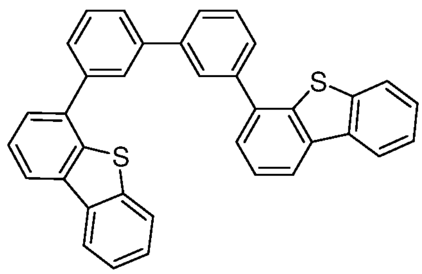

Hole Blocking Compound 1

Comparative Device 4

A device was prepared as described for Device Example 4 except that Compound Example 12 was replaced with Comparative Compound 12:

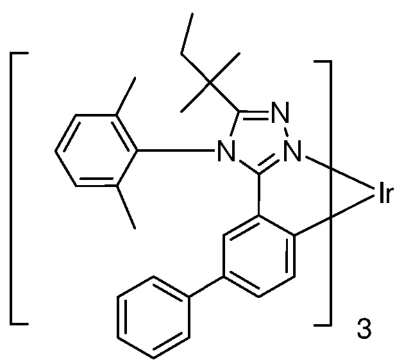

Comparative Compound 12

Figure 4 is a graph of luminance vs. time for Device Example 4 (Compound Example 12) and Comparative

Device 4 (Comparative Compound 12).

Although the present invention has been described in terms of specific exemplary embodiments, it will be appreciated that various modifications, alterations and/or combinations of features disclosed herein will be apparent to those skilled in the art without departing from the scope of the invention as set forth in the following claims.

## Claims

1. A phosphorescent compound of formula (Ia):

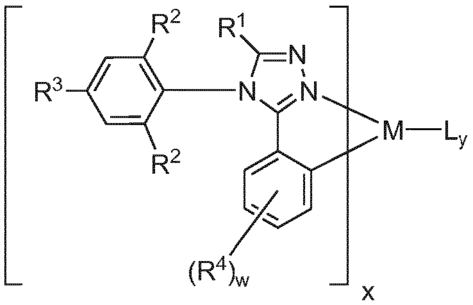

(Ia)

wherein:

M is selected from iridium, platinum, osmium, palladium, rhodium and ruthenium;
L in each occurrence is independently a mono- or poly-dentate ligand;
$R^1$ in each occurrence is independently a branched $C_{3-20}$ alkyl group, a cyclic $C_{5-20}$ alkyl group or group of formula (II):

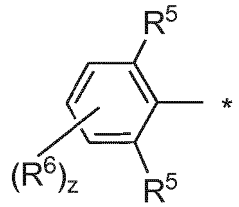

(II)

wherein each $R^5$ is independently a $C_{1-10}$ alkyl group; each $R^6$ is independently selected from F; CN; branched, linear or cyclic $C_{1-20}$ alkyl wherein non-adjacent C atoms of the $C_{1-20}$ alkyl may be replaced with -O-, -S-, -$NR^8$-, -$SiR^8_2$- or -COO- and one or more H atoms may be replaced with F, wherein $R^8$ is H or a substituent; z is 0 or a positive integer; and * is a point of attachment of the group of formula (II);
$R^2$ independently in each occurrence is a linear, branched or cyclic $C_{1-10}$ alkyl group
$R^3$ is a linear, branched or cyclic $C_{1-10}$ alkyl group or a group of formula -$(Ar^1)_p$ wherein $Ar^1$ in each occurrence is independently an aryl or heteroaryl group and p is at least 1;
$R^4$ is selected from a linear, branched or cyclic $C_{1-20}$ alkyl group and a group of formula -$(Ar^1)_p$;
w is 1;
x is at least 1; and
y is 0 or a positive integer.

2. A compound according to claim 1 wherein y is 0.

3. A compound according to claim 2 wherein x is 3.

**4.** A compound according to any one of the preceding claims wherein $R^1$ is a group of formula (II).

**5.** A compound according to claim 4 wherein each $R^5$ is independently a $C_{1-10}$ alkyl group.

**6.** A compound according to claim 4 or 5 wherein z is 0.

**7.** A compound according to any one of the preceding claims wherein $R^3$ is a $C_{1-20}$ alkyl group.

**8.** A compound according to any one of claims 1-6 wherein $Ar^1$ in each occurrence is independently phenyl that is unsubstituted or substituted with one or more $C_{1-10}$ alkyl groups.

**9.** A compound according to any one of the preceding claims wherein the compound has a photoluminescent spectrum having a peak wavelength in the range of 400-490 nm.

**10.** A compound according to any one of the preceding claims wherein $R^1$ is a branched $C_{4-20}$ alkyl group comprising a tertiary carbon atom.

**11.** A composition comprising a host material and a compound according to any one of the preceding claims.

**12.** A solution comprising a compound or composition according to any one of the preceding claims dissolved in one or more solvents.

**13.** An organic light-emitting device comprising an anode, a cathode and a light-emitting layer between the anode and cathode wherein the light-emitting layer comprises a compound or composition according to any one of claims 1-11.

**14.** An organic light-emitting device according to claim 13 wherein the device emits white light.

**15.** A method of forming an organic light-emitting device according to claim 13 or 14 comprising the step of depositing the light-emitting layer over one of the anode and cathode, and depositing the other of the anode and cathode over the light-emitting layer wherein the light-emitting layer is formed by depositing a solution according to claim 12 and evaporating the one or more solvents.

**Patentansprüche**

**1.** Phosphoreszierende Verbindung der Formel (Ia):

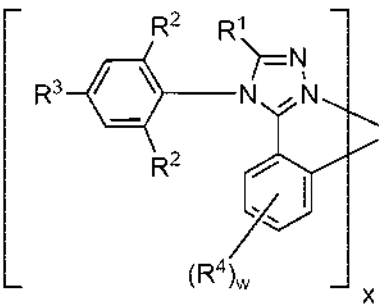

(Ia)

wobei:

M aus Iridium, Platin, Osmium, Palladium, Rhodium und Ruthenium ausgewählt ist;
L bei jedem Vorkommen unabhängig ein Mono- oder Polyzahnligand ist;
$R^1$ bei jedem Vorkommen unabhängig eine verzweigte $C_{3-20}$-Alkylgruppe, eine cyclische $C_{5-20}$-Alkylgruppe oder eine Gruppe der Formel (II) ist:

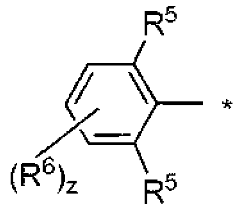

(II)

wobei jedes $R^5$ unabhängig eine $C_{1-10}$-Alkylgruppe ist; wobei jedes $R^6$ unabhängig aus F; CN; verzweigtem, linearem oder cyclischem $C_{1-20}$-Alkyl ausgewählt ist, wobei nicht benachbarte C-Atome des $C_{1-20}$-Alkyls durch -O-, -S-, -$NR^8$-, -$SiR^8_2$- oder -COO- substituiert sein können, und ein oder mehrere H-Atome durch F ersetzt sein können, wobei $R^8$ H oder ein Substituent ist; z 0 oder eine positive ganze Zahl ist; und * ein Anbringungspunkt der Gruppe der Formel (II) ist;

$R^2$ bei jedem Vorkommen unabhängig eine lineare, verzweigte oder cyclische $C_{1-10}$-Alkylgruppe ist;
$R^3$ eine lineare, verzweigte oder cyclische $C_{1-10}$-Alkylgruppe oder eine Gruppe der Formel -$(Ar^1)_p$ ist, wobei $Ar^1$ bei jedem Vorkommen unabhängig eine Aryl- oder Heteroarylgruppe ist und p mindestens 1 ist;
$R^4$ aus einer linearen, verzweigten oder cyclischen $C_{1-20}$-Alkylgruppe und einer Gruppe der Formel -$(Ar^1)_p$ ausgewählt ist;
w 1 ist;
x mindestens 1 ist; und
y 0 oder eine positive ganze Zahl ist.

2. Verbindung nach Anspruch 1, wobei y 0 ist.

3. Verbindung nach Anspruch 2, wobei x 3 ist.

4. Verbindung nach einem der vorhergehenden Ansprüche, wobei $R^1$ eine Gruppe der Formel (II) ist.

5. Verbindung nach Anspruch 4, wobei jedes $R^5$ unabhängig eine $C_{1-10}$-Alkylgruppe ist.

6. Verbindung nach Anspruch 4 oder 5, wobei z 0 ist.

7. Verbindung nach einem der vorhergehenden Ansprüche, wobei $R^3$ eine $C_{1-20}$-Alkylgruppe ist.

8. Verbindung nach einem der Ansprüche 1-6, wobei $Ar^1$ bei jedem Vorkommen unabhängig Phenyl ist, das nicht substituiert oder mit einer oder mehreren $C_{1-10}$-Alkylgruppen substituiert ist.

9. Verbindung nach einem der vorhergehenden Ansprüche, wobei die Verbindung ein Photolumineszenzspektrum mit einer Spitzenwellenlänge im Bereich von 400-490 nm aufweist.

10. Verbindung nach einem der vorhergehenden Ansprüche, wobei $R^1$ eine verzweigte $C_{4-20}$-Alkylgruppe ist, die ein tertiäres Kohlenstoffatom umfasst.

11. Zusammensetzung, umfassend ein Wirtsmaterial und eine Verbindung nach einem der vorhergehenden Ansprüche.

12. Lösung, umfassend eine Verbindung oder eine Zusammensetzung nach einem der vorhergehenden Ansprüche, aufgelöst in einem oder mehreren Lösungsmitteln.

13. Organische lichtemittierende Vorrichtung, umfassend eine Anode, eine Kathode und eine lichtemittierende Schicht zwischen der Anode und der Kathode, wobei die lichtemittierende Schicht eine Verbindung oder eine Zusammensetzung nach einem der Ansprüche 1-11 umfasst.

14. Organische lichtemittierende Vorrichtung nach Anspruch 13, wobei die Vorrichtung weißes Licht emittiert.

**15.** Verfahren zum Bilden einer organischen lichtemittierenden Vorrichtung nach Anspruch 13 oder 14, umfassend den Schritt des Abscheidens der lichtemittierenden Schicht über einer von der Anode und der Kathode und des Abscheidens der anderen von der Anode und der Kathode über der lichtemittierenden Schicht, wobei die lichtemittierende Schicht gebildet wird, indem eine Lösung nach Anspruch 12 abgeschieden und das eine oder die mehreren Lösungsmittel verdampft werden.

## Revendications

**1.** Composé phosphorescent de formule (Ia) :

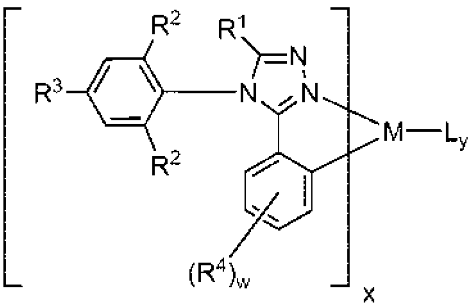

(Ia)

dans laquelle :

M est choisi parmi l'iridium, le platine, l'osmium, le palladium, le rhodium et le ruthénium ;
L dans chaque occurrence représente indépendamment un ligand mono- ou poly-dentate ;
$R^1$ dans chaque occurrence représente indépendamment un groupe alkyle ramifié en $C_{3-20}$, un groupe alkyle cyclique en $C_{5-20}$ ou un groupe de formule (II) :

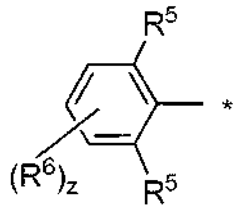

(II)

dans laquelle chaque $R^5$ représente indépendamment un groupe alkyle en $C_{1-10}$ ; chaque $R^6$ est indépendamment choisi parmi F ; CN ; un alkyle ramifié, linéaire ou cyclique en $C_{1-20}$ dans lequel les atomes de carbone non adjacents de l'alkyle en $C_{1-20}$ peuvent être remplacés par -O-, - S-, $-NR^8-$, $-SiR^8_2-$ ou -COO- et au moins un atome d'hydrogène peut être remplacé par F, dans laquelle $R^8$ représente H ou un substituant ; z vaut 0 ou est un nombre entier positif ; et *représente un point d'attache du groupe de formule (II) ;

$R^2$ représente indépendamment dans chaque occurrence un groupe alkyle linéaire, ramifié ou cyclique en $C_{1-10}$ ;
$R^3$ représente un groupe alkyle linéaire, ramifié ou cyclique en $C_{1-10}$ ou un groupe de formule $-(Ar^1)_p$ dans laquelle $Ar^1$ dans chaque occurrence représente indépendamment un groupe aryle ou hétéroaryle et p vaut au moins 1 ;
$R^4$ est choisi parmi un groupe alkyle linéaire, ramifié ou cyclique en $C_{1-20}$ et un groupe de formules-$(Ar^1)_p$ ;
w vaut 1 ;
x vaut au moins 1 ; et
y vaut 0 ou est un nombre entier positif.

2. Composé selon la revendication 1, dans lequel y vaut 0.

3. Composé selon la revendication 2, dans lequel x vaut 3.

4. Composé selon l'une quelconque des revendications précédentes, dans lequel $R^1$ est un groupe de formule (II).

5. Composé selon la revendication 4, dans lequel chaque $R^5$ représente indépendamment un groupe alkyle en $C_{1-10}$.

6. Composé selon la revendication 4 ou 5, dans lequel z vaut 0.

7. Composé selon l'une quelconque des revendications précédentes, dans lequel $R^3$ représente un groupe alkyle en $C_{1-20}$.

8. Composé selon l'une quelconque des revendications 1 à 6, dans lequel $Ar^1$ dans chaque occurrence représente indépendamment un phényle qui est non substitué ou substitué avec au moins un groupe alkyle en $C_{1-10}$.

9. Composé selon l'une quelconque des revendications précédentes, dans lequel le composé a un spectre de photoluminescence ayant une longueur d'onde de crête dans la plage allant de 400 à 490 nm.

10. Composé selon l'une quelconque des revendications précédentes, dans lequel $R^1$ représente un groupe alkyle ramifié en $C_{4-20}$ comprenant un atome de carbone tertiaire.

11. Composition comprenant un matériau hôte et le composé selon l'une quelconque des revendications précédentes.

12. Solution comprenant un composé ou composition selon l'une quelconque des revendications précédentes dissoutes dans au moins un solvant.

13. Dispositif organique électroluminescent comprenant une anode, une cathode et une couche électroluminescente située entre l'anode et la cathode, dans lequel la couche électroluminescente comprend un composé ou une composition selon l'une quelconque des revendications 1 à 11.

14. Dispositif organique électroluminescent selon la revendication 13, dans lequel le dispositif émet de la lumière blanche.

15. Procédé de formation de dispositif organique électroluminescent selon la revendication 13 ou 14 comprenant l'étape de dépôt de la couche électroluminescente sur l'une de l'anode et de la cathode, et de dépôt de l'autre de l'anode et de la cathode sur la couche électroluminescente, dans lequel la couche électroluminescente est formée par dépôt d'une solution selon la revendication 12 et d'évaporation de l'au moins un solvant.

FIGURE 1

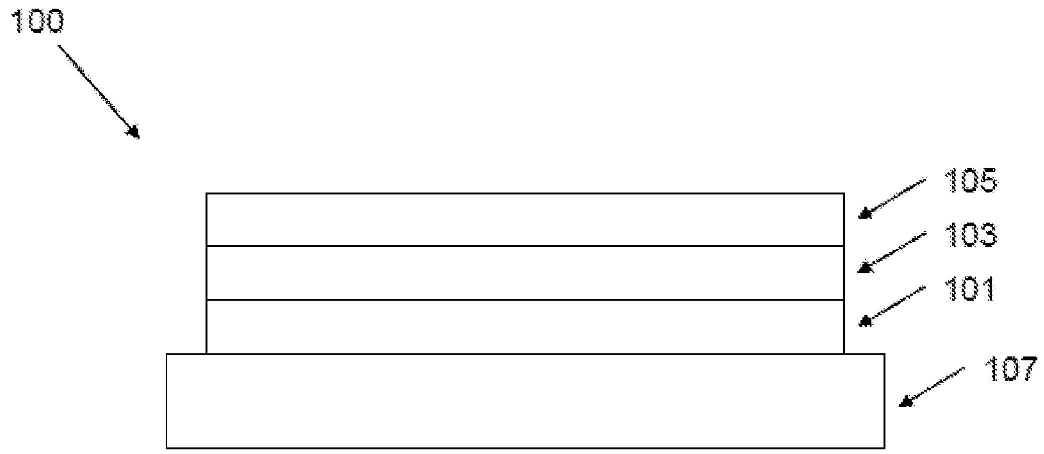


FIGURE 2

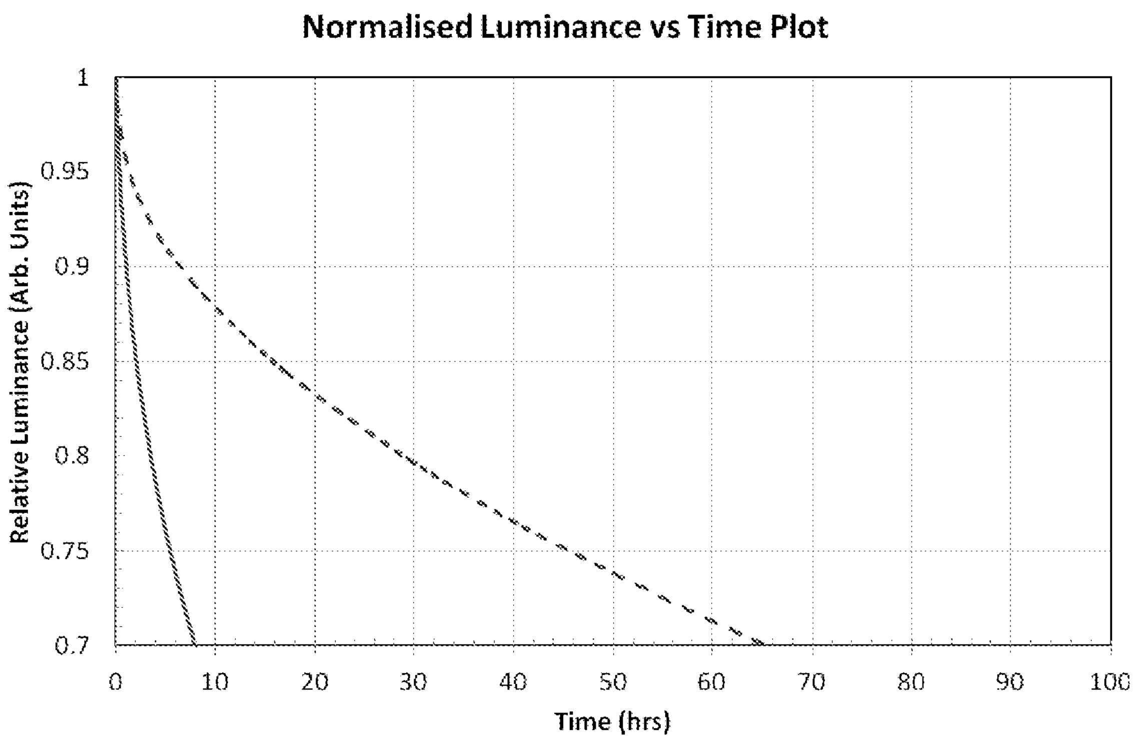

FIGURE 3

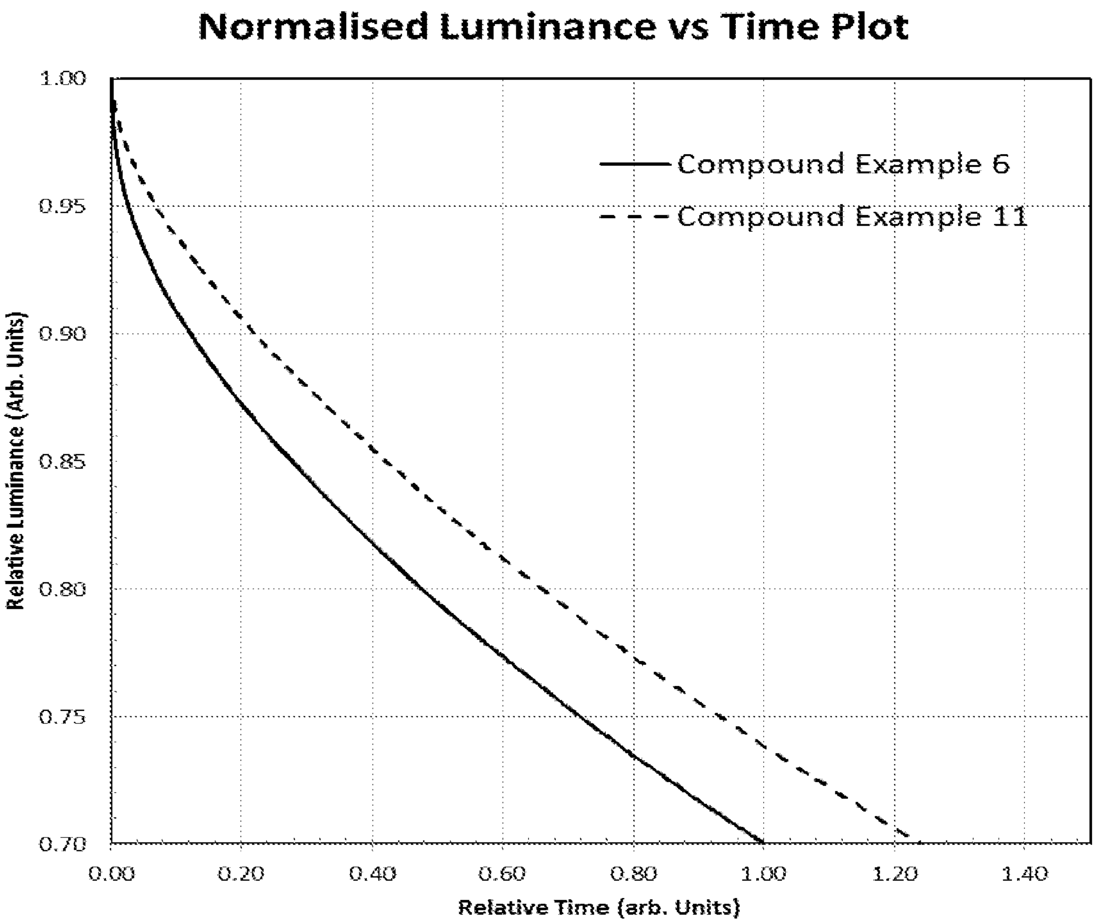
Normalised Luminance vs Time Plot
Compound Example 6
Compound Example 11
Relative Luminance (Arb. Units)
1.00
0.95
0.90
0.85
0.80
0.75
0.70
0.00
0.20
0.40
0.60
0.80
1.00
1.20
1.40
Relative Time (arb. Units)

FIGURE 4

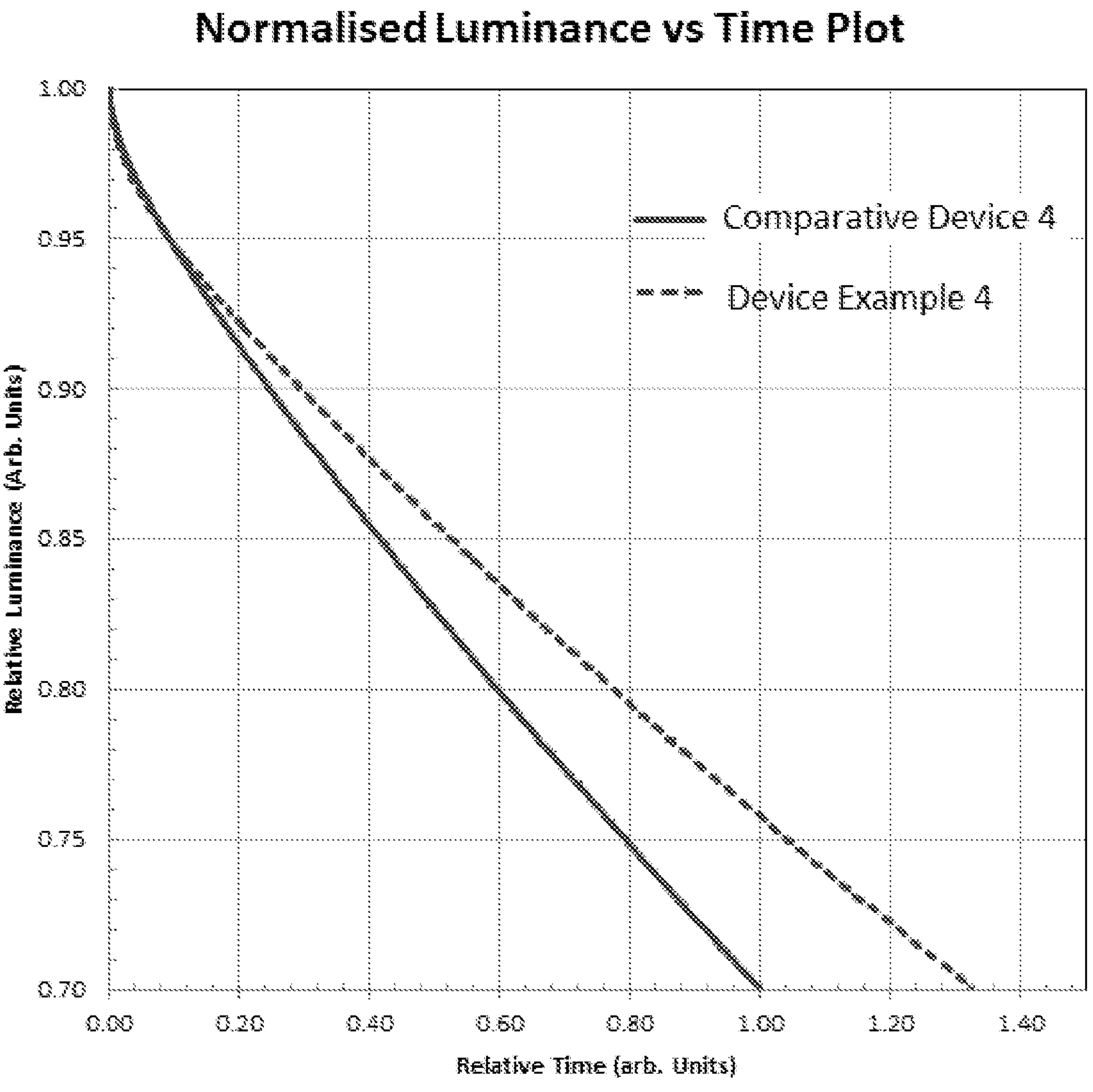
Normalised Luminance vs Time Plot
Comparative Device 4
Device Example 4
Relative Luminance (Arb. Units)
1.00
0.95
0.90
0.85
0.80
0.75
0.70
0.00
0.20
0.40
0.60
0.80
1.00
1.20
1.40
Relative Time (arb. Units)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2014374727 A
- JP 2012222268 B
- US 2012248969 A
- US 2014151659 A
- WO 2011052516 A
- WO 2014085296 A
- US 2013221278 A
- JP 2011253980 A
- EP 0842208 A
- EP 0707020 A
- WO 0053656 A
- EP 0901176 A
- EP 0947123 A
- US 5723873 A
- US 5798170 A
- WO 9810621 A
- WO 9857381 A
- WO 0284759 A
- WO 0048258 A
- GB 2348316 A
- US 6268695 B
- EP 0949850 A
- WO 0181649 A
- WO 0119142 A
- EP 0880303 A
- WO 2012133229 A


### Non-patent literature cited in the description


- *J. Appl. Phys.,* 1989, vol. 65, 3610
- **Y.V. ROMAOVSKII et al.** *Physical Review Letters,* 2000, vol. 85 (5), 1027
- **A.VAN DIJKEN et al.** *Journal of the American Chemical Society,* 2004, vol. 126, 7718
- *Adv. Mater.,* 2000, vol. 12 (23), 1737-1750
- *J. Appl. Phys.,* 1996, vol. 79, 934
- *Macromolecules,* 2000, vol. 33 (6), 2016-2020
- **SHIROTA ; KAGEYAMA.** *Chem. Rev.,* 2007, vol. 107, 953-1010
- **T. YAMAMOTO.** Electrically Conducting And Thermally Stable pi-Conjugated Poly(arylene)s Prepared by Organometallic Processes. *Progress in Polymer Science,* 1993, vol. 17, 1153-1205
- *Journal of Physics D: Applied Physics,* 1996, vol. 29 (11), 2750-2753
- *Appl. Phys. Lett.,* 2002, vol. 81 (4), 634
- *Appl. Phys. Lett.,* 2001, vol. 79 (5
- **MICHAELSON.** *J. Appl. Phys.,* 1977, vol. 48 (11), 4729